**Europäisches Patentamt**

**European Patent Office**

**Office européen des brevets**

(19)

(11) Publication number : **0 488 703 A1**

# (12) EUROPEAN PATENT APPLICATION

(21) Application number : **91310978.1**

(22) Date of filing : **28.11.91**

(51) Int. Cl.$^5$ : **C25D 13/22**

(30) Priority : **28.11.90 JP 326318/90**

(43) Date of publication of application :
**03.06.92 Bulletin 92/23**

(84) Designated Contracting States :
**DE FR GB**

(71) Applicant : **SOMAR CORPORATION**
**11-2, Ginza 4-chome Chuo-ku**
**Tokyo 104 (JP)**

(72) Inventor : **Seki, Mitsuhiro**
**2-10-501, Toyo 2-chome, Koto-ku**
**Tokyo (JP)**

(74) Representative : **Allam, Peter Clerk et al**
**LLOYD WISE, TREGEAR & CO. Norman House**
**105-109 Strand**
**London WC2R 0AE (GB)**

(54) **Electrodeposition process and device.**

(57) An electrically conducting surface is applied with an electrodeposition paint by brush coating, roll coating, flow coating or the like coating method using a paint applicator having a container for containing the paint. An electrode is disposed in the container for contact with the paint contained in the container. Simultaneously with the application of the paint, a direct current voltage is continuously impressed between the electrode and the conducting surface to effect electrodeposition of the paint onto the conducting surface.

EP 0 488 703 A1

This invention relates to an electrodeposition process for forming a coating over an electrically conducting surface and to a device for carrying out the process.

Electrodeposition is a method in which electrically charged coat-forming particles dispersed in an aqueous medium are deposited by electrophoresis onto an electrically conducting surface. This method is used in various fields such as for forming a primer layer on an automobile body or for forming a photoresist layer on a copper layer of a copper clad laminate. Known electrodeposition process includes impressing a direct current voltage between an electrically conducting surface to be coated and an electrode both of which are immersed in a bath of an electrodeposition paint. Thus, in order to coat a large body, it is necessary to use a large electrophoresis vessel. Further, the conventional immersion type process requires a relatively long electrodeposition time.

The present invention has been made to provide a new electrodeposition process which can be performed with a high speed in a continuous manner using a small-sized device. In accordance with the present invention there is provided an electrodeposition process for forming a coating over an electrically conducting surface, comprising the steps of:

(a) providing an applicator including a container for containing an electrodeposition paint, application means connected to said container for discharging the paint from said container therethrough, and an electrode disposed for contact with the paint contained in said container; and

(b) continuously discharging the paint from said container through said applying means to maintain said electrode in electrical contact with said conducting surface through the paint;

(c) simultaneously with step (b), moving said applicator relative to said conducting surface to apply the paint to said conducting surface; and

(d) simultaneously with step (b), impressing a direct current voltage between said electrode and said conducting surface.

In another aspect, the present invention provides a device for forming a coating over an electrically conducting surface, comprising:

an applicator having a container for containing an electrodeposition paint and means for applying the paint;

an electrode disposed for contact with the paint contained in said container;

means for moving said applicator relative to said conducting surface;

a source of a direct current; and

means for electrically connecting said electrode and said conducting surface with said direct current source.

The present invention will now be described in detail below with reference to the accompanying drawings, in which:

Fig. 1 is a fragmentary, cross-sectional view diagrammatically showing a paint applicator according to the present invention; and

Figs. 2-5 are cross-sectional views diagrammatically showing various other embodiments of a paint applicator according to the present invention.

In the present invention, an electrodeposition paint is applied to an electrically conductive surface to be coated using a paint applicator. Any material having an electrically conductive surface can be coated according to the present invention. Illustrative of suitable electrically conducting surfaces are those of metals such as copper, aluminum and iron, carbon and electrically conducting organic materials such as polymers.

Any conventionally known electrodeposition paint, such as of a thermosetting type, a photo-curable type or a photodecomposition type, may be utilized for the purpose of the present invention. Known electrodeposition paints are two-folded into anionic and cationic types and both types may be utilizable for the process of the present invention.

Anionic electrodeposition paints contain coat-forming particles having an anionic group such as a carboxyl group, a sulfonic group or a phosphoric group. Cationic electrodeposition paints contain coat-forming particles having a cationic group such as an organic ammonium group or a pyridinium group. These electrodeposition paints are disclosed in, for example, United States patents Nos. 4,845,012 and 4,898,656.

The paint applicator to be used for carrying out the process of the present invention includes a container for containing an electrodeposition paint, application means connected to the container for discharging the paint from the container therethrough, and an electrode disposed for contact with the paint contained in the container. The applicator is displaced relative to the conducting surface to be coated while continuously discharging the paint from the container through the applying means to maintain the electrode in electrical contact with the conducting surface through the paint, so that the paint in the container is applied on the conducting surface. In this case, a direct current voltage (generally 100-300 V, 2-10 A/dm$^2$ (ampere per 100 cm$^2$)) is impressed between the electrode and the conducting surface so that the coat-forming particles are deposited onto the conducting surface.

The relative movement of the applicator may be effected either by displacing the applicator while maintaining the conducting surface unmoved or by displacing the conducting surface while maintaining the applicator unmoved. The speed at which the relative movement is performed is generally 4 m/minute or less, preferably 0.5-2 m/minute.

The impression of the direct current is performed such that the electrode is electrically connected to the positive electric pole of the direct current source while the conducting surface is electrically connected to the negative electric pole when the paint is a cationic paint. When the paint is anionic one, on the other hand, the electrode is connected to the negative pole while the conducting surface is connected to the positive pole.

It is preferred that the space between the electrode and the conducting surface be as small as possible because of effective utilization of electric power. The space is preferably less than 50 mm, more preferably 20 mm or less.

The thickness of the coating obtained by the electrical deposition method according to the present invention may be controlled by control of the direct current applied between the electrode and the conducting surface, the distance therebetween and the speed of the movement of the conducting surface relative to the paint applicator and is, generally, 3-15 μm. If desired, the coating operation may be repeated twice or more to increase and/or uniformize the thickness. However, since electrical resistance increases with the increase in the thickness of the coating, no merit is obtained by repeating the coating operation a number of times. Generally the coating operation is conducted only once or repeated 2 or 3 times. Repetition of the coating operation may be suitably effected by using two or more paint applicators arranged in series with respect to the relative movement of the conductive surface to be treated. The conducting surface thus subjected to the electrodeposition is then treated to remove the remaining paint therefrom, washed with water and dried. The dried coating is then subjected to a curing treatment, for example, by irradiation of actinic light or by heating.

As the means for applying the paint, there may be used various types of coaters such as a roll coater, a brush coater, a curtain coater, a spin coater and a flow coater.

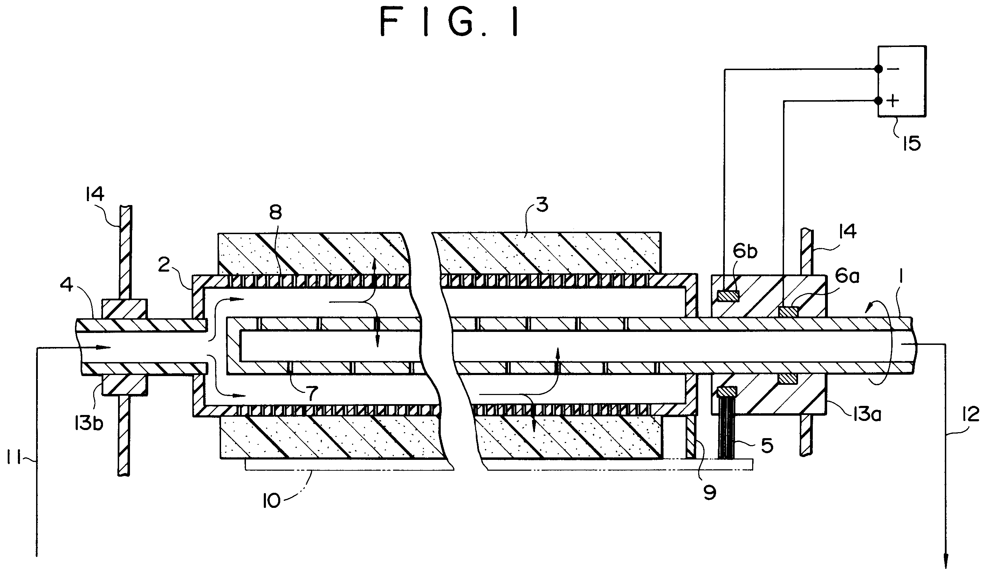

Fig. 1 depicts one preferred embodiment of the paint applicator of a roll coater type. Designated as 2 is an outer cylindrical member formed of an electrically insulating material such as a synthetic resin or a ceramic and serving as a container for containing an electrodeposition paint. The outer cylindrical member 2 is closed at one end thereof with the other end thereof being is connected to an inlet conduit 4 through which the electrodeposition paint is fed from a line 11. The cylindrical member 2 has a multiplicity of perforations 8 distributed on the periphery thereof.

Provided on the outer periphery of the cylindrical member 2 is a porous layer 3 of an electrically insulating material such as a rubber foam, a foamed resin, a sponge or a fiber.

An inner cylindrical member 1 formed of a metal and serving as an electrode is coaxially disposed inside of the outer cylindrical member 2 and integrally connected thereto. The cylindrical electrode 1 is closed at one end thereof, extends through the closed end of the outer cylindrical member 2 and is connected at the other end thereof to a line 12. A multiplicity of perforations 7 are provided on the periphery of the electrode 1.

The outer and inner cylindrical members 2 and 1 are fixed to each other and are rotatably supported by sleeves 13a and 13b secured to a frame 14. Designated as 6a and 6b are terminal rings embedded within the sleeve 13a. The terminal ring 6a is maintained in contact with an outer periphery of the inner cylindrical electrode 1 and is electrically connected to one of the terminal ends of a power source 15 of a direct current.

The terminal ring 6b has a brush electrode 5 extending for engagement with a substrate having a conducting surface 10 and is connected to the other terminal ends of the direct current source 15. The ring electrode 6a is electrically connected to the positive terminal of the direct current source 15 while the ring electrode 6b is electrically connected to the negative terminal when the paint used is a cationic paint. When the paint is anionic one, on the other hand, the electrode 6a is connected to the negative terminal while the electrode 6b is connected to the positive terminal.

Designated as 9 is a resilient plate such as a rubber plate extending for pressure contact with the conducting surface 10 to prevent liquid flow therethrough. If desired, a tubular ion-exchange membrane (not shown) may be disposed to between the inner and outer cylindrical members 1 and 2 to facilitate the separation of cations from anions.

The above applicator operates as follows.

An electrodeposition paint, for example a cationic paint, is fed by means of a pump (not shown) from a line 11 to the outer cylindrical member 2 and is passed through the openings 8 to the porous layer 3. The paint absorbed in the layer 3 is applied onto the conductive surface 10 by rolling contact of the roll 3 with the conducting surface 10. The paint in the outer cylindrical member 2 is also passed through the opening 7 to the inside of the inner cylindrical member 1 and is discharged through a line 12. In this case, a direct current is applied between the conducting surface 10 and the inner cylindrical member 1 so that the cations (coat-forming particles) are deposited on the conducting surface 10 while anions are discharged through the line 12. The paint discharged through the line 12 may be recycled to the line 11, if desired.

When both sides of the substrate 10 are to be coated, it is convenient to use a pair of the above roll-type applicator disposed in parallel to form a nip therebetween. By passing the substrate 10 through the nip, both sides thereof may be simultaneously coated. Further, by disposing two paint applicators in series, the conducting surface 10 can be subjected twice to the electrodeposition treatment.

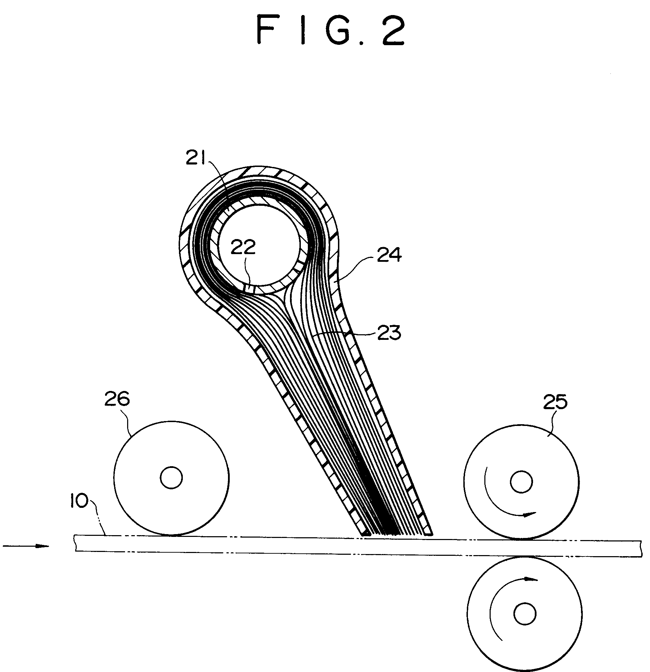

Fig. 2 depicts another embodiment of paint applicator according to the present invention equipped with a brush coater of a covered brush squeeze type. Designated as 21 is an electrically conducting tube whose opposite open ends are connected to paint feed and discharge lines (not shown) and through which the paint flows by operation of a pump (not shown). The tube 21 is electrically connected to a source of a direct current. An electrically insulating cover 24 is disposed to surround the tube 21. The cover 24 is provided with a radially outwardly extending portion whose open end is formed into a slit. Provided in the space defined between the tube 21 and the cover 24 is a brush 23 formed of an electrically insulating fiber such as a synthetic resin fiber or a natural fiber. The tube 21 has a plurality of openings 22 so that the paint in the tube 21 is passed therethrough into the space of the brush. A substrate 10 having a conductive surface is continuously displaced by means of a pair of insulating rolls 25. Designated as 26 is a metal roll maintained in rolling contact with the conductive surface 10. The roll 26 is electrically connected to the direct current source. The above brush coater is disposed so that the tip of the brush 23 impregnated with the pain is sliding contact with the conductive surface 10. Thus, the paint is applied onto the conductive surface 10. In this case, since a direct current voltage is applied between the tube 21 and the conductive surface, the coat-forming ingredients of the paint are deposited on the conductive surface 10.

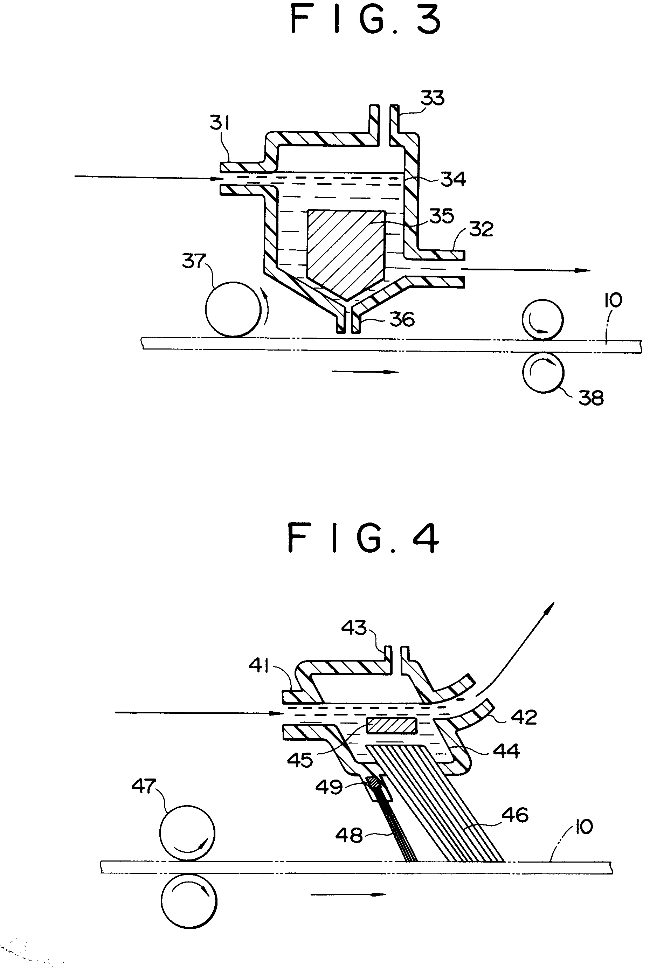

Fig. 3 shows a further embodiment of paint applicator which is of a curtain coater type. Designated as 34 is a container formed of an electrically insulating material and having paint feed and discharge ports 31 and 32 and a gas discharge port 33. Provided in the bottom of the container 34 is a slit-like opening 36 from which the paint flows down to form a curtain-like liquid film. A metal bar 35 which is electrically connected to a source of a direct current (not shown) is disposed within the container 34 adjacent to the slit 36. A substrate 10 having a conductive surface is continuously displaced by means of a pair of insulating rolls 38. Designated as 37 is a metal roll maintained in rolling contact with the conductive surface 10. The roll 37 is electrically connected to the direct current source. The paint in the form of a curtain is contacted with the conductive surface 10 to effect electrodeposition in the same manner as the foregoing embodiments.

Fig. 4 shows a further embodiment of paint applicator which is of a brush coater type. Designated as 44 is a container formed of an electrically insulating material and having paint feed and discharge ports 41 and 42 and a gas discharge port 43. Provided in the bottom of the container 44 is a laterally extending slit through which a brush 46 extends out of the container 44. A metal bar 45 which is electrically connected to a source of a direct current (not shown) is disposed within the container 44 adjacent to the brush 46. Designated as 48 is an electrically conducting, laterally arranged brush planted in the wall of the container 44 and connected to a terminal bar 49 which, in turn, is electrically connected to the direct current source. A substrate 10 having a conductive surface is continuously displaced by means of a pair of insulating rolls 47. The brush impregnated with the paint is contacted with the conductive surface 10 to effect electrodeposition in the same manner as the foregoing embodiments.

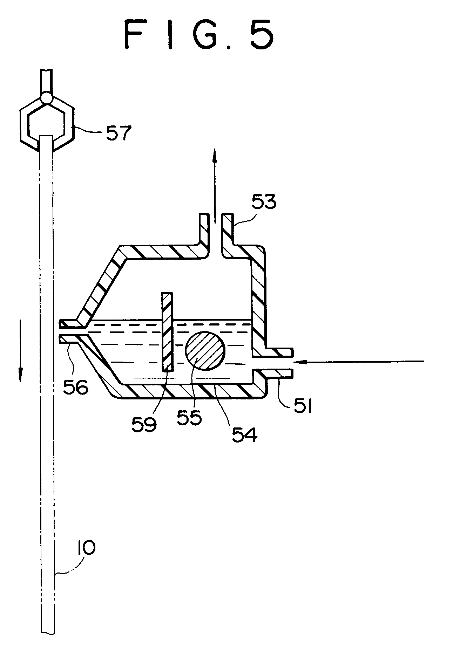

Fig. 5 shows yet a further embodiment of paint applicator. Designated as 54 is a container formed of an electrically insulating material and having a paint feed port 51 and a gas discharge port 53. Provided in the side wall of the container 54 is a laterally extending, slit-like opening 56 from which the paint overflows to form a curtain-like liquid film. A metal bar 55 which is electrically connected to a source of a direct current (not shown) is disposed within the container 54 adjacent to the slit 56. Designated as 59 is a partition disposed to prevent gases formed on the metal bar 55 from being discharged from the slit 56. A substrate 10 having a conductive surface is cramped and continuously displaced by means of a metal cramp 57 which is electrically connected to the direct current source. The paint in the form of a curtain or a wave is contacted with the conductive surface 10 to effect electrodeposition in the same manner as the foregoing embodiments.

If desired, the partition 59 may be replaced by an ion exchange membrane disposed to form an open topped chamber within the inside of the container 54. The electrode 55 is placed within the chamber so that the counter ions opposite to the ions of the coat-forming particles are collected in the chamber. An discharge conduit extends into the chamber to discharge the counter ion-rich liquid therethrough from the chamber. A supply conduit also extends into the chamber to make up the liquid in the chamber.

In the foregoing embodiments, when both sides of the substrate 10 are to be coated, it is convenient to use a pair of opposing paint applicators. By displacing the substrate 10 between the two applicators, both sides thereof can be simultaneously applied with the electrodeposition paint.

The process of the present invention may be applied to form a coating over a conductive surface of various substrates. In particular, the electrodeposition method is suitably applied in the field of production of printed wiring boards for the formation of a photoresist layer or a primer layer for a photosensitive dry film to be provided over a copper layer of a copper clad laminate.

The following examples will further illustrate the present invention.

## Example 1

A copper clad laminate was subjected to an electrodeposition treatment by means of an apparatus as shown in Fig. 5 using an anionic electrodeposition paint (ZONNE EDUV No. 376, manufactured by Kansai Paint Inc.). The laminate was moved at a constant speed of 1.0 m/minute. The electrodeposition was performed by application of DC voltage of 250 V, electric current of 5 A/dm². The coating operation was repeated twice. The coated laminate was washed with water and dried to obtain a photoresist coating having a thickness of 6 μm. The coating was then applied with a 3 % aqueous polyvinyl alcohol solution (GOSENOL NM-14 manufactured by Nihon Gosei K. K.) to form a thin cover film. The photoresist coating was exposed to a high pressure mercury lamp (200 mJ/cm²) to form a pattern with a line space of 100 μm. The exposed surface was developed with 1% $Na_2CO_3$, etched with copper chloride and then treated with NaOH solution to remove the photoresist, thereby to obtain a wiring pattern.

## Example 2

A copper clad laminate having through-holes with a diameter of 0.8 mm was subjected to an electrodeposition treatment in the same manner as that in Example 1 except that PRIME COAT AN-100 was used as the electrodeposition paint and that the laminate was moved at 2.0 m/minute. As a result, a coating having a thickness of about 3 μm was formed. The coating was overlaid with a photosensitive dry film (LISTON 4220, manufactured by du Pont Inc.). The film was exposed to a high pressure mercury lamp (100 mJ/cm²) to form a tenting pattern with a line space of 100 μm. The exposed surface was developed with 1% $Na_2CO_3$, etched with copper chloride and then treated with NaOH solution to remove the resist, thereby to obtain a wiring pattern. Because of the the primer coating formed by the electrodeposition treatment, the through-holes were protected from the etching solution. Further, since the primer coating also served to cover scratches or flaws on the conductive surface, the wiring pattern was not discontinued on the scratches.

## Example 3

A copper clad laminate having through-holes with a diameter of 0.4 mm was subjected to an electrodeposition treatment in the same manner as that in Example 1 except that the laminate was moved at 2.0 m/minute. As a result, a coating having a thickness of about 3 μm was formed. The coating was overlaid with a photosensitive dry film (LAMINAR HG, manufactured by Dynachem Inc.). The film was exposed to a high pressure mercury lamp (70 mJ/cm²) to form a plating pattern. The exposed surface was developed with 1% $Na_2CO_3$, plated with cupric sulfate, plated with tin/lead, treated with methylene chloride to remove the resist and etched with an alkali, thereby to obtain a plating pattern. Because of the the primer coating formed by the electrodeposition treatment, no undesirable deposits of plating were observed.

## Claims

1. An electrodeposition process for forming a coating over an electrically conducting surface, comprising the steps of:
   (a) providing an applicator including a container for containing an electrodeposition paint, application means connected to said vessel for discharging the paint from said container therethrough, and an electrode disposed for contact with the paint contained in said container; and
   (b) continuously discharging the paint from said container through said applying means to maintain said electrode in electrical contact with said conducting surface through the paint;
   (c) simultaneously with step (b), moving said applicator relative to said conducting surface to apply the paint to said conducting surface; and
   (d) simultaneously with step (b), impressing a direct current voltage between said electrode and said conducting surface.

2. The process according to claim 1, wherein said relative movement of said applicator is performed by displacing said applicator while maintaining said conducting surface unmoved.

3. The process according to claim 1, wherein said relative movement of said applicator is performed by displacing said conducting surface while maintaining said applicator unmoved.

4. The process according to claim 1, wherein the paint is cationic paint and wherein said electrode is electrically connected to a positive electric pole of a direct current source while said conducting surface is electrically connected to a negative electric pole thereof.

5. The process according to claim 1, wherein the paint is anionic paint and wherein said electrode is electrically connected to a negative electric pole of a direct current source while said conducting surface is electrically connected to a positive electric pole thereof.

6. A device for forming a coating over an electrically conducting surface, comprising:

an applicator having a container for containing an electrodeposition paint and means for applying the paint;

an electrode disposed for contact with the paint contained in said container;

means for moving said applicator relative to said conducting surface;

a source of a direct current; and

means for electrically connecting said electrode and said conducting surface with said direct current source.

7. A device according to claim 6, wherein said means for applying the paint includes a brush, a roll, a nozzle or an overflowing port which is in liquid communication with said container.

# FIG. 1

EP 0 488 703 A1

# F I G. 2

# F I G. 3

# F I G. 4

# F I G. 5

57

53

56

59 55 54

51

10

**European Patent Office**

## EUROPEAN SEARCH REPORT

Application Number

EP 91 31 0978

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-1 451 978 (BERGER JENSON AND NICHOLSON LTD) <br><br> * page 1, line 27 - line 89 * <br> --- | 1,2,3,4, 5,6,7 | C25D13/22 |
| X | DE-B-1 646 168 (WOLKSWAGENWERK AG) <br><br> * column 4, line 31 - line 56; figure 5 * <br> --- | 1,2,3,4, 5,6,7 | |
| X | FR-A-2 318 948 (STANDARD T CHEMICAL CO) <br><br> * figure 16 * <br><br> ----- | 1,2,3,4, 5,6,7 | |
| | | | **TECHNICAL FIELDS SEARCHED (Int. Cl.5 )** <br><br> C25D |

The present search report has been drawn up for all claims

| Place of search | Date of completion of the search | Examiner |
|---|---|---|
| THE HAGUE | 04 FEBRUARY 1992 | NGUYEN THE NGHIEP N. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)